# FASCICULE DE BREVET EUROPEEN

(11) **EP 4 269 331 B1**
(45) Date de publication et mention de la délivrance du brevet: **16.10.2024**
(21) Numéro de dépôt: 23170086.5
(22) Date de dépôt: 26.04.2023
(51) Int. Cl.: B81C 1/00

(54) **PROCEDE DE FABRICATION D'UN DISPOSITIF MEMS**
VERFAHREN ZUR HERSTELLUNG EINER MEMS-VORRICHTUNG
METHOD OF MANUFACTURING A MEMS DEVICE

(30) Priorité: 29.04.2022 FR 2204075
(43) Date de publication de la demande: 01.11.2023
(73) Titulaire: Commissariat à l'énergie atomique et aux énergies alternatives, 75015 Paris (FR)
(72) Inventeur: BERTHELOT, Audrey, 38054 Grenoble Cedex 09 (FR); ROBERT, Philippe, 38054 Grenoble Cedex 09 (FR)
(74) Mandataire: Cabinet Beaumont

(56) Documents cités:
- EP-A1- 2 599 745
- EP-A2- 2 952 472
- PH. ROBERT ET AL: "M&NEMS: A new approach for ultra-low cost 3D inertial sensor", 2009 IEEE SENSORS, 1 October 2009 (2009-10-01), pages 963 - 966, XP055023740, ISBN: 978-1-42-444548-6, DOI: 10.1109/ICSENS.2009.5398195

## Description

### Domaine technique

La présente description concerne de façon générale les dispositifs électromécaniques et notamment les dispositifs basés sur des microsystèmes électromécaniques ou MEMS (de l'anglais "Micro Electro Mechanical Systems"). Elle s'applique tout particulièrement à des dispositifs basés sur des micro- et nano-systèmes électromécaniques ou M&NEMS (de l'anglais "Micro and Nano-ElectroMechanical Systems").

### Technique antérieure

Un dispositif MEMS comprend typiquement au moins un élément mécanique, par exemple une masse sismique, présentant des dimensions micrométriques. Cet élément peut prendre diverses formes selon la fonction recherchée du dispositif. Les dispositifs MEMS peuvent par exemple être utilisés pour mettre en oeuvre des fonctions de mesure de diverses natures, par exemple des mesures de déplacement ou de pression. Des dispositifs MEMS sont par exemple utilisés dans des capteurs de type accéléromètre, gyromètre, des capteurs de pressions, etc.

Des examples de procédé de fabrication de dispositifs MEMS de l'art antérieurs sont divulgués dans les documents suivants:
PH. ROBERT ET AL: "M&NEMS: A new approach for ultra-low cost 3D inertial sensor",2009 IEEE SENSORS, 1 octobre 2009 (2009-10-01), pages 963-966; EP 2 599 745 A1 et EP 2 952 472 A2

Il serait souhaitable d'améliorer au moins en partie certains inconvénients des dispositifs MEMS connus et de leurs procédés de fabrication.

### Résumé de l'invention

Pour cela, un mode de réalisation prévoit un procédé de fabrication d'un dispositif micro-électromécanique comportant les étapes successives suivantes :
- prévoir une structure SOI comportant une première couche semiconductrice sur une couche isolante ;
- former une deuxième couche semiconductrice par épitaxie sur et en contact avec la face supérieure de la première couche semiconductrice ;
- reporter et fixer, par collage moléculaire, une troisième couche semiconductrice sur et en contact avec la face supérieure de la deuxième couche semiconductrice ; et
- former des tranchées s'étendant verticalement depuis la face supérieure de la troisième couche semiconductrice jusqu'à la face supérieure de la couche isolante, lesdites tranchées délimitant latéralement un élément mécanique du dispositif.

Selon un mode de réalisation, les première, deuxième et troisième couches semiconductrices sont en silicium.

Selon un mode de réalisation, l'étape de formation des tranchées est suivie par une étape de libération, dans laquelle la couche isolante est retirée sous l'élément mécanique.

Selon un mode de réalisation, l'étape de report de la troisième couche semiconductrice sur la deuxième couche semiconductrice est précédée d'une étape de nettoyage par traitement plasma de la face inférieure de la troisième couche semiconductrice et/ou de la face supérieure de la deuxième couche semiconductrice.

Selon un mode de réalisation, l'élément mécanique a une épaisseur comprise entre 10 µm et 300 µm, par exemple entre 20 µm et 100 µm, par exemple entre 30 µm et 80 µm, par exemple entre 40 µm et 60 µm.

Selon un mode de réalisation, le procédé comprend en outre, avant l'étape de formation de la deuxième couche semiconductrice, une étape de gravure localisée de la première couche semiconductrice de façon à définir dans ladite première couche semiconductrice des éléments de transduction électromécanique de dimensions microniques ou submicroniques.

Selon un mode de réalisation, le procédé comprend après ladite étape de gravure localisée et avant l'étape de formation de la deuxième couche semiconductrice, une étape de formation d'éléments de protection en un matériau isolant localisés en vis à vis desdits éléments de transduction électromécanique de dimensions microniques ou submicroniques.

Selon un mode de réalisation, les éléments de protection sont retirés avec la couche isolante lors de l'étape de libération.

Un autre mode de réalisation prévoit un dispositif micro-électromécanique comportant un élément mécanique comprenant, dans son épaisseur, une première couche semiconductrice, une deuxième couche semiconductrice formée par épitaxie sur et en contact avec la face supérieure de la première couche semiconductrice, et une troisième couche semiconductrice fixée, par collage moléculaire, sur et en contact avec la face supérieure de la deuxième couche semiconductrice.

Selon un mode de réalisation, l'élément mécanique a une épaisseur comprise entre 10 µm et 300 µm, par exemple entre 20 µm et 100 µm, par exemple entre 30 µm et 80 µm, par exemple entre 40 µm et 60 µm.

Selon un mode de réalisation, le dispositif comprend en outre des éléments de transduction électromécanique de dimensions microniques ou submicroniques formés dans la première couche semiconductrice.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :

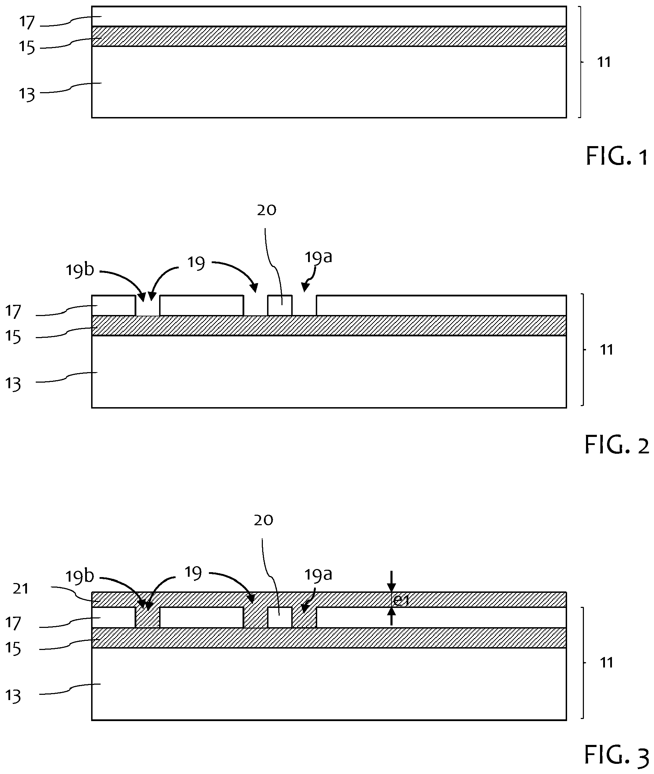

la figure 1, la figure 2, la figure 3, la figure 4, la figure 5, la figure 6, la figure 7 et la figure 8 sont des vues en coupe illustrant de façon partielle et schématique des étapes successives d'un exemple d'un procédé de fabrication d'un dispositif MEMS selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, seules certaines des étapes du procédé de fabrication des dispositifs MEMS et seuls certains éléments des dispositifs MEMS ont été détaillés, les autres étapes et éléments étant des étapes et éléments usuels ou étant à la portée de la personne du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Les figures 1 à 8 illustrent, de façon schématique et partielle, des étapes d'un exemple d'un procédé de fabrication d'un dispositif MEMS selon un mode de réalisation. Plus particulièrement, dans cet exemple, le dispositif réalisé est un dispositif M&NEMS, comprenant des éléments de transduction électromécanique de dimensions microniques ou submicroniques, par exemple de dimensions nanométriques, ou éléments NEMS, par exemple des jauges de contrainte ou des actionneurs, couplés à des éléments mécaniques de dimensions micrométriques ou éléments MEMS, par exemple une masse sismique. Sur les figures 1 à 8, la réalisation d'un unique dispositif MEMS a été (partiellement) représentée. En pratique, une pluralité de dispositifs MEMS, par exemple identiques ou similaires, peuvent être formés simultanément à partir d'un même substrat de départ, puis singularisés lors d'une étape de découpe, non détaillée.

La figure 1 représente une structure de départ 11 de type SOI (de l'anglais "Semiconductor On Insulator" - semiconducteur sur isolant). La structure 11 comprend, par exemple un support 13 en un matériau semiconducteur, surmonté d'une couche électriquement isolante 15, elle-même surmontée d'une couche semiconductrice 17.

A titre d'exemple, le support 13 est en silicium. Le support 13 a, par exemple, une épaisseur comprise entre 200 µm et 800 µm, par exemple entre 500 µm et 750 µm.

A titre d'exemple, la couche isolante 15 est en un oxyde, par exemple en oxyde de silicium (SiO₂). La couche isolante 15 a par exemple une épaisseur comprise entre 0,1 µm et 4 µm, par exemple entre 0,3 µm et 3 µm, par exemple de l'ordre de 2 µm.

A titre d'exemple, la couche semiconductrice 17 est en silicium, par exemple en silicium monocristallin. La couche semiconductrice 17 a par exemple une épaisseur comprise entre 50 nm et 50 µm, par exemple entre 200 nm et 2 µm, par exemple égale à environ 250 nm ou environ 500 nm. A titre d'exemple, la couche semiconductrice 17 est dopée.

A titre d'exemple, la couche isolante 15 est formée sur et en contact avec le support 13 de sorte que la face inférieure de la couche isolante 15 soit en contact avec la face supérieure du support 13. La couche semiconductrice 17 est par exemple formée sur et en contact avec la couche isolante 15 de sorte que la face inférieure de la couche semiconductrice 17 soit en contact avec la face supérieure de la couche isolante 15.

La figure 2 illustre la structure obtenue à l'issue d'une étape de gravure localisée de la couche semiconductrice 17 de façon à former, dans celle-ci, des ouvertures 19. Les ouvertures 19 traversent, par exemple, de part en part la couche semiconductrice 17, c'est-à-dire qu'elles traversent la couche 17 sur toute son épaisseur, de façon à exposer la face supérieure de la couche isolante 15.

Les ouvertures 19 comprennent notamment des tranchées 19a délimitant latéralement un ou plusieurs éléments de transduction électromécanique de dimensions microniques ou submicroniques (NEMS) 20 du dispositif. Les éléments 20 sont par exemple des jauges de contrainte, par exemple des poutres résonantes ou des jauges piézorésistives, comportant chacune un ou plusieurs barreaux de silicium de dimensions nanométriques définis dans la couche de silicium 17 de la structure SOI.

Les ouvertures 19 peuvent en outre comprendre au moins une ouverture 19b destinée à permettre la reprise ultérieure d'un contact électrique sur le support semiconducteur 13 sous-jacent.

Les ouvertures 19a et 19b sont par exemple formées simultanément lors d'une même étape de photolithographie et gravure.

La figure 3 illustre la structure obtenue à l'issue d'une étape de dépôt d'une couche électriquement isolante 21 sur la face supérieure de la structure de la figure 2. La couche isolante 21 s'étend par exemple de façon continue sur toute la surface supérieure de la structure, c'est à dire, dans cet exemple, sur la face supérieure de la couche semiconductrice 17 et dans les ouvertures 19. A titre d'exemple, la couche isolante 21 s'étend sur et en contact avec la face supérieure de la couche semiconductrice 17 en dehors des ouvertures 19, et sur et en contact avec la face supérieure de la couche isolante 15 et avec les flancs de la couche semiconductrice 17 dans les ouvertures 19.

La couche 21 est par exemple en oxyde de silicium. La couche 21 présente par exemple une épaisseur e1, mesurée au-dessus de la surface de la couche conductrice 17, comprise entre 50 nm et 2 µm, par exemple comprise entre 0,1 µm et 0,5 µm, par exemple de l'ordre de 0,3 µm. A titre d'exemple, la couche 21 comble entièrement les ouvertures 19. La couche 21 présente par exemple une face supérieure sensiblement plane s'étendant de façon continue sur toute la surface supérieure de la structure.

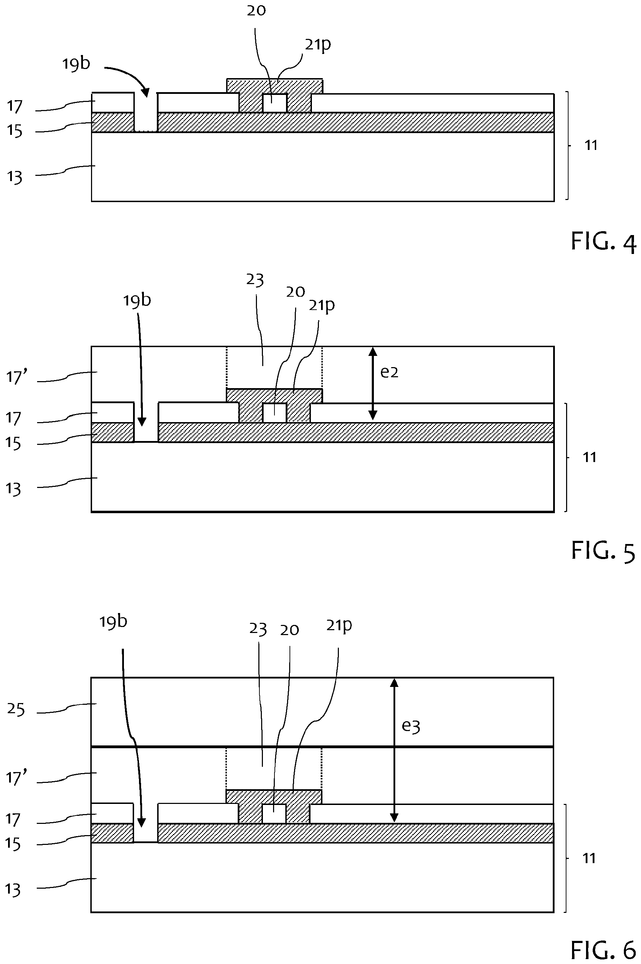

La figure 4 illustre la structure obtenue à l'issue d'une étape de retrait localisé de la couche isolante 21, par exemple par photolithographie et gravure. A titre d'exemple, la couche 21 est retirée sur sensiblement toute la face supérieure de la structure illustrée en figure 3 sauf en vis-à-vis des éléments NEMS 20 et des tranchées 19a délimitant latéralement ces éléments. Ainsi, à l'issue de cette étape, seules subsistent des portions 21p de la couche 21, recouvrant la face supérieure et les flancs des éléments NEMS 20 de manière protéger les éléments NEMS 20. Lors de cette étape, la couche 21 est retirée dans la ou les ouvertures de reprise de contact 19b. De plus, lors de cette étape, la gravure se prolonge à travers la couche isolante 15 de la structure SOI en vis à vis de l'ouverture 19b, jusqu'à exposer la face supérieure du substrat 13 et ainsi permettre la reprise d'un contact électrique appelé contact de masse sur le substrat 13.

La figure 5 illustre la structure obtenue à l'issue d'une étape de dépôt épitaxiale d'une couche semiconductrice 17', par exemple en le même matériau que la couche 17, sur la face supérieure de la structure de la figure 4. Dans cet exemple, la couche 17' s'étend de façon continue sur toute la surface de la structure et comble notamment les ouvertures 19b. Ainsi, en vis à vis des ouvertures 19b, la couche 17' vient en contact, par sa face inférieure, avec la face supérieure du substrat 13.

La couche 17' est formée par croissance épitaxiale à partir de la face supérieure de la couche semi-conductrice 17. Ainsi, la couche 17' est par exemple monocristalline sur sensiblement toute la surface de la structure, sauf en vis à vis des régions de protection isolantes 21p recouvrant les éléments NEMS 20 du dispositif, où la couche 17' peut présenter une structure polycristalline. Dans l'exemple de la figure 5, la partie polycristalline de la couche 17' située sur et en contact avec les régions isolantes de protection 21p des éléments NEMS est désignée par la référence 23.

A titre d'exemple, la couche 17' est dopée in-situ, par exemple, au bore, lors de son dépôt.

A l'issue de l'étape de dépôt, la face supérieure de la couche 17' peut ne pas être plane. En effet, la croissance n'a pas nécessairement la même vitesse en vis-à-vis des ouvertures 19b, en vis à vis des régions isolantes de protection 21p, et en vis à vis des portions de la face supérieure de la couche 17 non revêtues par les régions isolantes 21p. De préférence, une étape de planarisation de la face supérieure de la couche 17' est mise en oeuvre à l'issue de l'étape de dépôt.

A titre d'exemple, à l'issue de l'étape de planarisation, les couches 17 et 17' présentent, en dehors des ouvertures 19b et des régions de formation des éléments NEMS 20 du dispositif, une épaisseur cumulée e2, à partir de la face supérieure de la couche isolante enterrée 15, comprise entre 1 µm et 50 µm, par exemple comprise entre 5 µm et 30 µm, par exemple comprise entre 10 µm et 20 µm.

A titre d'exemple, l'étape de planarisation est réalisée par CMP (polissage mécano physique, de l'anglais "Chemical Mechanical Polishing"). En variante, l'étape de planarisation est réalisée par un polissage ou meulage mécanique (grinding) suivi d'un polissage sec (dry polish). Encore en variante, l'étape de planarisation est réalisée par une combinaison des techniques décrites ci-avant.

La figure 6 illustre la structure obtenue à l'issue d'une étape de report d'une couche semiconductrice 25 sur la face supérieure de la structure illustrée en figure 5 et plus particulièrement, sur la face supérieure de la couche 17'. A titre d'exemple, la couche 25 est reportée sur et en contact avec la face supérieure de la couche 17'. A titre d'exemple, la couche semiconductrice 25 est une plaquette semiconductrice (wafer) ou une partie de plaquette semiconductrice. La couche 25 est par exemple en le même matériau que la couche 17', par exemple en silicium. La couche 25 est de préférence monocristalline. La couche 25 est, par exemple dopée. A titre d'exemple, la couche 25 correspond à la couche semiconductrice cristalline supérieure d'une structure SOI. Dans ce cas, le substrat de support de la structure SOI peut servir de poignée lors du report. Après report et fixation de la couche 25 sur la face supérieure de la couche 17', le substrat de support et la couche isolante enterrée de la structure SOI peuvent être retirés de façon à conserver uniquement la couche 25. A titre de variante, la couche 25 correspond à une partie de l'épaisseur d'un substrat semiconducteur massif. Le substrat est d'abord reporté et fixé sur la face supérieure de la couche 17', puis aminci, par exemple par meulage et/ou CMP, de façon à conserver uniquement la couche 25.

La couche 25 est par exemple fixée par collage moléculaire de sa face inférieure avec la face supérieure de la couche 17'. Le collage est par exemple un collage moléculaire de type SAB (de l'anglais "Surface Activated Bonding" - collage à activation de surface), c'est à dire que l'étape de report est précédée d'une étape de préparation ou nettoyage de la surface de collage de la couche 25 et/ou de la surface de collage de la couche 17', par traitement plasma.

Pour améliorer le collage, après report de la couche 25 sur et en contact avec la face supérieure de la couche 17', un recuit peut être prévu, par exemple à une température de l'ordre de 400°C.

En dehors des ouvertures 19b et des régions de formation des éléments NEMS 20 du dispositif, les couches 17, 17' et 25 présentent une épaisseur cumulée e3. L'épaisseur e3 est, par exemple, déterminée en fonction du type d'élément MEMS que l'on cherche à réaliser. L'épaisseur e3 correspond, par exemple, à l'épaisseur finale d'un élément mécanique, par exemple une masse sismique, d'un élément MEMS du dispositif. L'épaisseur e3 peut être ajustée en fonction du type d'application considéré. L'épaisseur e3 est, par exemple, comprise entre 10 µm et 300 µm, par exemple entre 20 µm et 100 µm, par exemple entre 30 µm et 80 µm, par exemple entre 40 et 60 µm.

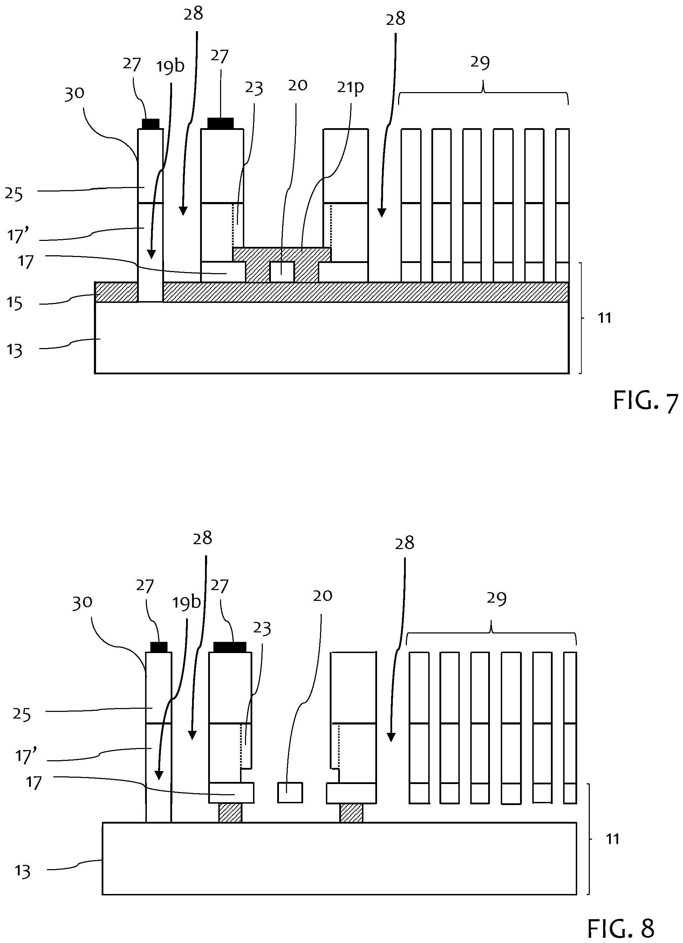

La figure 7 illustre la structure obtenue à l'issue d'une étape de gravure localisée, à partir de la face supérieure de la couche 25, de l'empilement formé par les couches 17, 17' et 25.

A titre d'exemple, l'étape de gravure est réalisée à travers un masque, par exemple un masque dur, en un oxyde, par exemple en orthosilicate de tétraéthyle (TEOS). La gravure des couches 25, 17' et 17 est, par exemple une gravure ionique réactive profonde (DRIE, de l'anglais "Deep Reactive Ion Etching") .

Lors de cette étape des ouvertures et/ou tranchées verticales 28 sont formées dans l'empilement des couches 25, 17' et 17. A titre d'exemple, ces tranchées et/ou ouvertures débouchent sur la face supérieure de la couche 15 ou sur la face supérieure des protections 21p. La gravure est par exemple une gravure sélective du ou des matériaux semiconducteurs des couches 17, 17' et 25 par rapport au matériau diélectrique de la couche 15 et des éléments de protection 21. Les tranchées et ouvertures 28 définissent et délimitent latéralement, dans l'empilement des couches semiconductrices 17, 17' et 25, des éléments MEMS comprenant notamment un élément mécanique 29, par exemple une masse sismique. Dans cet exemple, les tranchées et ouvertures 28 permettent en outre d'exposer la face supérieure des éléments de protection 21p en vis à vis des éléments NEMS 20 du dispositif. De plus, dans cet exemple, les tranchées et ouvertures 28 définissent en outre, en vis à vis de l'ouverture de reprise de contact de masse 19b, une portion 30 de l'empilement des couches 17' et 17, aussi appelée région de reprise de contact de masse, en contact, par sa face inférieure, avec le substrat 13.

A titre d'exemple, l'étape de gravure décrite ci-avant est précédée d'une étape de formation de plots 27, par exemple sur et en contact avec la face supérieure de la couche semiconductrice 25, en vis à vis de portions de la couche 25 non retirées lors de l'étape de gravure ultérieure et en dehors des éléments MEMS et notamment de l'élément mécanique 29 du dispositif. A titre d'exemple, les plots 27 sont en germanium et ont, par exemple, une épaisseur comprise entre 100 nm et 1 µm, par exemple de l'ordre de 500 nm. Les plots 27 permettent, par exemple, le scellement ultérieur de la structure obtenue à l'issue du procédé décrit en relation avec les figures 1 à 8 avec un capot (non représenté).

La figure 8 illustre la structure obtenue à l'issue d'une étape de retrait d'une partie de la couche 15 et des régions de protection isolantes 21p. Lors de cette étape, aussi appelée étape de libération, la couche 15 et les éléments de protection 21p sont gravés de façon sélective par rapport aux couches semiconductrices 17, 17' et 25, de manière à libérer les éléments MEMS et NEMS du dispositif. A titre d'exemple, la gravure est une gravure chimique gazeuse. A titre d'exemple, la gravure est réalisée sous vapeur de fluorure d'hydrogène (HF). A titre d'exemple, la libération a une vitesse comprise entre 5 nm/min et 100 nm/min, par exemple comprise entre 20 nm/min et 60 nm/min, par exemple de l'ordre de 48 nm/min. Le temps de gravure peut être contrôlé de façon à conserver des portions de la couche diélectrique 15 servant d'ancrage ou support mécanique aux éléments MEMS et NEMS du dispositif.

A titre d'exemple, des parties de silicium polycristallin peuvent subsister dans la structure obtenue à l'issue de cette étape. En effet, à titre d'exemple, à proximité des éléments NEMS 20, une partie des régions 23 peut subsister.

Un avantage du procédé décrit ci-dessous et notamment de l'étape de la figure 6 de report d'une couche semiconductrice 25 sur et en contact avec la face supérieure de la couche semiconductrice épitaxiée 17', est qu'il permet d'augmenter l'épaisseur de l'élément mécanique par rapport à un procédé ne comportant pas cette étape et dans lequel l'épaisseur de l'élément mécanique serait définie uniquement par l'épaisseur des couches 17 et 17'. Ceci permet d'améliorer les performances des dispositifs MEMS et d'adresser des applications nécessitant des éléments mécaniques, par exemple des masses sismiques, relativement épais.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent aux exemples de matériaux et de dimensions mentionnés dans la présente description.

Enfin, la mise en oeuvre pratique des modes de réalisation et variantes décrits est à la portée de la personne du métier à partir des indications fonctionnelles données ci-dessus.

## Revendications

1. Procédé de fabrication d'un dispositif micro-électromécanique comportant les étapes successives suivantes :
- prévoir une structure SOI comportant une première couche semiconductrice (17) sur une couche isolante (15) ;
- former une deuxième couche semiconductrice (17') par épitaxie sur et en contact avec la face supérieure de la première couche semiconductrice (17) ; **caractérisé en ce que** le procédé comprend en sus les étapes suivantes:
- reporter et fixer, par collage moléculaire, une troisième couche semiconductrice (25) sur et en contact avec la face supérieure de la deuxième couche semiconductrice (17') ; et
- former des tranchées s'étendant verticalement depuis la face supérieure de la troisième couche semiconductrice (25) jusqu'à la face supérieure de la couche isolante (15), lesdites tranchées délimitant latéralement un élément mécanique (29) du dispositif.

2. Procédé selon la revendication 1, dans lequel les première (17), deuxième (17') et troisième (25) couches semiconductrices sont en silicium.

3. Procédé selon la revendication 1 ou 2, dans lequel l'étape de formation des tranchées est suivie par une étape de libération, dans laquelle la couche isolante (15) est retirée sous l'élément mécanique (29).

4. Procédé selon l'une quelconque des revendications 1 à 3, dans lequel l'étape de report de la troisième couche semiconductrice (25) sur la deuxième couche semiconductrice (17') est précédée d'une étape de nettoyage par traitement plasma de la face inférieure de la troisième couche semiconductrice (25) et/ou de la face supérieure de la deuxième couche semiconductrice (17').

5. Procédé selon l'une quelconque des revendications 1 à 4, dans lequel l'élément mécanique a une épaisseur (e3) comprise entre 10 µm et 300 µm, par exemple entre 20 µm et 100 µm, par exemple entre 30 µm et 80 µm, par exemple entre 40 µm et 60 µm.

6. Procédé selon l'une quelconque des revendications 1 à 5, comprenant en outre, avant l'étape de formation de la deuxième couche semiconductrice (17'), une étape de gravure localisée de la première couche semiconductrice (17) de façon à définir dans ladite première couche semiconductrice (17) des éléments de transduction électromécanique (20) de dimensions microniques ou submicroniques.

7. Procédé selon la revendication 6, comprenant en outre, après ladite étape de gravure localisée et avant l'étape de formation de la deuxième couche semiconductrice (17'), une étape de formation d'éléments de protection (21p) en un matériau isolant localisés en vis à vis desdits éléments de transduction électromécanique (20) de dimensions microniques ou submicroniques.

8. Procédé selon la revendication 7 dans son rattachement à la revendication 3, dans lequel les éléments de protection (21p) sont retirés avec la couche isolante (15) lors de l'étape de libération.

9. Dispositif micro-électromécanique comportant un élément mécanique (29) comprenant, dans son épaisseur, une première couche semiconductrice (17), une deuxième couche semiconductrice (17') formée par épitaxie sur et en contact avec la face supérieure de la première couche semiconductrice (17), **caractérisé en ce que** le dispositif comprend également une troisième couche semiconductrice (25) fixée, par collage moléculaire, sur et en contact avec la face supérieure de la deuxième couche semiconductrice (17').

10. Dispositif selon la revendication 9, dans lequel l'élément mécanique (29) a une épaisseur (e3) comprise entre 10 µm et 300 µm, par exemple entre 20 µm et 100 µm, par exemple entre 30 µm et 80 µm, par exemple entre 40 µm et 60 µm.

11. Dispositif selon la revendication 9 ou 10, comprenant en outre des éléments de transduction électromécanique (20) de dimensions microniques ou submicroniques formés dans la première couche semiconductrice (17).

## Patentansprüche

1. Verfahren zum Herstellen eines mikroelektromechanischen Gerätes welches die folgenden aufeinanderfolgenden Schritte aufweist:
- Bereitstellen einer SOI-Struktur mit einer ersten Halbleiterschicht (17) auf einer Isolierschicht (15);
- Bilden einer zweiten Halbleiterschicht (17') durch Epitaxie auf und in Kontakt mit der oberen Fläche der ersten Halbleiterschicht (17); **dadurch gekennzeichnet, dass** das Verfahren zusätzlich die folgenden Schritte aufweist:
- Übertragen und Bonden, durch molekulares Bonden, einer dritten Halbleiterschicht (25) auf und in Kontakt mit der oberen Oberfläche der zweiten Halbleiterschicht (17'); und
- Bilden von Gräben, die sich vertikal von der oberen Oberfläche der dritten Halbleiterschicht (25) zur oberen Oberfläche der Isolierschicht (15) erstrecken, wobei die Gräben seitlich ein mechanisches Element (29) des Geräts begrenzen.

2. Verfahren nach Anspruch 1, wobei die erste (17), die zweite (17') und die dritte (25) Halbleiterschicht aus Silizium hergestellt sind.

3. Verfahren nach Anspruch 1 oder 2, wobei sich an den Schritt des Bildens der Gräben ein Schritt des Lösens anschließt, bei dem die Isolierschicht (15) unter dem mechanischen Element (29) entfernt wird.

4. Verfahren nach einem der Ansprüche 1 bis 3, wobei dem Schritt des Übertragens der dritten Halbleiterschicht (25) auf die zweite Halbleiterschicht (17') ein Schritt des Reinigens durch Plasmabehandlung vorausgeht, und zwar der unteren Oberfläche der dritten Halbleiterschicht (25) und/oder der oberen Oberfläche der zweiten Halbleiterschicht (17').

5. Verfahren nach einem der Ansprüche 1 bis 4, wobei das mechanische Element eine Dicke (e3) im Bereich von 10 µm bis 300 µm, z.B. von 20 µm bis 100 µm, z.B. von 30 µm bis 80 µm, z.B. von 40 µm bis 60 µm hat.

6. Verfahren nach einem der Ansprüche 1 bis 5, ferner aufweisend vor dem Schritt des Bildens der zweiten Halbleiterschicht (17') einen Schritt des lokalen Ätzens der ersten Halbleiterschicht (17), um in der ersten Halbleiterschicht (17) elektromechanische Wandlerelemente (20) mit Abmessungen im Mikrometer- oder Submikrometerbereich zu definieren.

7. Verfahren nach Anspruch 6, ferner aufweisend, nach dem Schritt des lokalen Ätzens und vor dem Schritt des Bildens der zweiten Halbleiterschicht (17'), einen Schritt des Bildens von Schutzelementen (21p) aus einem isolierenden Material, die vor den elektromechanischen Wandlerelementen (20) mit Abmessungen im Mikrometer- oder Submikrometerbereich angeordnet sind.

8. Verfahren nach Anspruch 7 in Abhängigkeit von Anspruch 3, wobei die Schutzelemente (21p) zusammen mit der Isolierschicht (15) während des Schritts des Lösens entfernt werden.

9. Mikroelektromechanisches Gerät mit einem mechanischen Element (29), aufweisend über seine gesamte Dicke eine erste Halbleiterschicht (17), eine zweite Halbleiterschicht (17'), die durch Epitaxie auf der oberen Oberfläche der ersten Halbleiterschicht (17) und in Kontakt mit dieser gebildet ist, **dadurch gekennzeichnet, dass** das Gerät ferner Folgendes aufweist:
eine dritte Halbleiterschicht (25), die durch molekulares Bonden auf die obere Fläche der zweiten Halbleiterschicht (17') gebondet ist und mit dieser in Kontakt steht.

10. Gerät nach Anspruch 9, wobei das mechanische Element (29) eine Dicke (e3) im Bereich von 10 µm bis 300 µm, zum Beispiel von 20 µm bis 100 µm, zum Beispiel von 30 µm bis 80 µm, zum Beispiel von 40 µm bis 60 µm hat.

11. Vorrichtung nach Anspruch 9 oder 10, ferner aufweisend elektromechanische Wandlerelemente (20) mit Abmessungen im Mikrometer- oder Submikrometerbereich, die in der ersten Halbleiterschicht (17) gebildet sind.

## Claims

1. Method of manufacturing a microelectromechanical device comprising the following successive steps:
- providing an SOI structure comprising a first semiconductor layer (17) on an insulating layer (15);
- forming a second semiconductor layer (17') by epitaxy on top of and in contact with the upper surface of the first semiconductor layer (17); **characterized in that** the method comprises, in addition, the following steps
- transferring and bonding, by molecular bonding, a third semiconductor layer (25) onto and in contact with the upper surface of the second semiconductor layer (17'); and
- forming trenches vertically extending from the upper surface of the third semiconductor layer (25) to the upper surface of the insulating layer (15), said trenches laterally delimiting a mechanical element (29) of the device.

2. Method according to claim 1, wherein the first (17), second (17'), and third (25) semiconductor layers are made of silicon.

3. Method according to claim 1 or 2, wherein the step of forming of the trenches is followed by a disengagement step, where the insulating layer (15) is removed under the mechanical element (29).

4. Method according to any of claims 1 to 3, wherein the step of transfer of the third semiconductor layer (25) onto the second semiconductor layer (17') is preceded by a step of cleaning by plasma treatment of the lower surface of the third semiconductor layer (25) and/or of the upper surface of the second semiconductor layer (17').

5. Method according to any of claims 1 to 4, wherein the mechanical element has a thickness (e3) in the range from 10 µm to 300 µm, for example, from 20 µm to 100 µm, for example, from 30 µm to 80 µm, for example, from 40 µm to 60 µm.

6. Method according to any of claims 1 to 5, further comprising, before the step of forming of the second semiconductor layer (17'), a step of local etching of the first semiconductor layer (17) to define in said first semiconductor layer (17) electromechanical transduction elements of (20) micrometer- or sub-micrometer-range dimensions.

7. Method according to claim 6, further comprising, after said local etching step and before the step of forming of the second semiconductor layer (17'), a step of forming of protection elements (21p) made of an insulating material located in front of said electromechanical transduction elements (20) of micrometer- or sub-micrometer-range dimensions.

8. Method according to claim 7 as dependent on claim 3, wherein the protection elements (21p) are removed with the insulating layer (15) during the disengagement step.

9. Microelectromechanical device comprising a mechanical element (29) comprising, across its thickness, a first semiconductor layer (17), a second semiconductor layer (17') formed by epitaxy on top of and in contact with the upper surface of the first semiconductor layer (17), **characterized in that** the device comprises also: a third semiconductor layer (25) bonded, by molecular bonding, on top of and in contact with the upper surface of the second semiconductor layer (17').

10. Device according to claim 9, wherein the mechanical element (29) has a thickness (e3) in the range from 10 µm to 300 µm, for example from 20 µm to 100 µm, for example from 30 µm to 80 µm, for example, from 40 µm to 60 µm.

11. Device according to claim 9 or 10, further comprising electromechanical transduction elements (20) of micrometer- or sub-micrometer-range dimensions formed in the first semiconductor layer (17).
